# EUROPÄISCHE PATENTANMELDUNG

(11) **EP 2 101 274 A1**
(43) Veröffentlichungstag der Anmeldung: **16.09.2009**
(21) Anmeldenummer: 08004814.3
(22) Anmeldetag: 14.03.2008
(51) Int. Cl.: G06F 17/50

(54) **Verfahren zur Bestimmung von Kenngrössen für die Auslegung eines Bauteils und Vorrichtung enthaltend ein derartiges Bauteil**

(71) Anmelder: Fraunhofer-Gesellschaft zur Förderung der angewandten Forschung e.V., 80686 München (DE)
(72) Erfinder: Bitsch, Gerd, Dr., 67691 Hochspeyer (DE); Dressler, Klaus, Dr., 66879 Kollweiler (DE)
(74) Vertreter: Pfenning, Meinig & Partner GbR

(57) **Zusammenfassung**

Die vorliegende Erfindung betrifft ein Verfahren zur Bestimmung von Kenngrößen für die Auslegung eines Bauteils sowie eine Vorrichtung, die ein derartiges Bauteil enthält und die Bestimmung von Kenngrößen für die Auslegung des Bauteils ermitteln kann.

Erfindungsgemäß werden in dem Verfahren zur Bestimmung von Kenngrößen für die Auslegung eines Bauteils einfach zu bestimmende Messwerte im bestimmungsgemäßen Betrieb des Bauteils erfasst und als Eingangsgröße für eine Mehrkörpersimulation des Bauteils verwendet. Das Simulationsmodell hat als Ausgangsgröße beanspruchungs- und/oder bemessungsrelevante Kenngrößen, die für die Auslegung des Bauteils, beispielsweise seine Dimensionierung bzw. Materialwahl für das Bauteil als Kenngrößen relevant sind.

## Beschreibung

Die vorliegende Erfindung betrifft ein Verfahren zur Bestimmung von Kenngrößen für die Auslegung eines Bauteils sowie eine Vorrichtung, die ein derartiges Bauteil enthält.

Bei der Auslegung von Bauteilen und Systemen bezüglich der Ertragbarkeit von Betriebsbelastungen, Sonder- oder Missbrauchsereignissen spielt zum einen die Beanspruchbarkeit des Bauteils bzw. des Systems zum anderen die auftretende Beanspruchung eine Rolle. Typischerweise sind die im späteren Betrieb auftretenden Beanspruchungen vorab nicht oder nur unzureichend bekannt. Aus diesem Grund müssen im Auslegungsprozess Annahmen über die zu erwartenden Beanspruchungen getroffen werden Die Auslegung basiert auf diesen getroffenen Annahmen, deren Unsicherheiten gegebenenfalls z.B. durch die Einführung von Sicherheitsfaktoren abgefangen werden sollen. Zwei wesentliche Probleme bei dieser Vorgehensweise sind:
- Die Annahmen beruhen, wenn überhaupt, auf nur stichprobenartig durchgeführten Messungen, wobei diesen Messungen auch wiederum nur vage Annahmen über den später zu erwarteten Einsatz zugrunde liegen,
- eine standardmäßige spätere Kontrolle der im Betrieb auftretenden Beanspruchungen findet in der Regel nicht statt, da diese i.A. messtechnisch zu aufwändig und damit wirtschaftlich nicht vertretbar ist.

Ein typisches Beispiel stellt der Auslegungsprozess bezüglich der Ertragbarkeit von Betriebsbeanspruchungen, Sonder- oder Missbrauchsereignissen in der PKW- oder LKW-Entwicklung dar. Basierend auf vereinzelt durchgeführten - als kundenrelevant angenommenen - Messfahrten mit messtechnisch speziell ausgerüsteten Fahrzeugen, werden im Betrieb auftretende Belastungen erfasst. Aus diesen erfassten Daten wird abgeleitet, wie Fahrten auf Teststrecken, Prüfstandsversuche oder auch Simulationen durchgeführt werden sollen, um abzusichern, dass das Fahrzeug später betriebssicher ist. Ein unerwartetes Versagen im späteren (Kunden-) Betrieb, insbesondere sicherheitsrelevanter Bauteile, soll damit weitgehend ausgeschlossen werden. Nachteilig ist jedoch, dass
- ein Abgleich, inwieweit die Annahme über Größe und Verteilung der im Betrieb auftretenden Belastungen auf Basis der als kundennah erachteten Messungen tatsächlich gegeben ist, nicht stattfindet.
- eine Kontrolle, in wieweit die im tatsächlichen Betrieb auftretenden Beanspruchungen unter- oder oberhalb der zugrunde gelegten Auslegungskriterien liegen, aus oben genannten Gründen ebenfalls nicht stattfindet.

Gemäß dem Stand der Technik wurden also Bemessungsgrundlagen in der Regel nach Gefühl und mit subjektiver Erfahrung erstellt. Durch Ausstattung ausgewählter Fahrzeuge mit Messtechnik und Erfassung von Daten mittels dieser Messtechnik zur Erstellung von Bemessungsgrundlagen wird dieses Verfahren bisher fundierter gestaltet. Die aufwendige und teuere Messtechnik bedingt jedoch, dass nur relativ wenige Fahrzeuge ausgestattet werden und daher Vorabannahmen über den praxisrelevanten Einsatz und die hierbei herrschenden Einsatzbedingungen getroffen werden müssen. Diese Annahmen beeinflussen jedoch selbstverständlich auch die Bestimmung der Bemessungsgrundlagen anhand der mittels spezieller Messfahrzeuge ermittelten Werte. Eine Erfassung der tatsächlichen Höhe und Verteilung der im realen Alltagsbetrieb auftretenden Beanspruchungen für die Gesamtheit der im Betrieb befindlichen Fahrzeuge findet hier nicht statt.

Die vorliegende Erfindung macht es sich daher zur Aufgabe, ein einfaches und wirksames Verfahren zur Bestimmung von realitätsnahen Kenngrößen für die Auslegung eines Bauteils anzugeben und Vorrichtungen, beispielsweise Fahrzeuge, anzugeben, die derartige Bauteile enthalten und die Bestimmung von Kenngrößen für die Auslegung des Bauteiles ermöglichen.

Diese Aufgabe wird durch das Verfahren nach Anspruch 1 und die Vorrichtung nach Anspruch 5 gelöst. Vorteilhafte Weiterbildungen des erfindungsgemäßen Verfahrens und des erfindungsgemäßen Bauteils werden in den jeweiligen abhängigen Ansprüchen gegeben.

Erfindungsgemäß wird an dem auszulegenden Bauteil ein Sensor angeordnet, wobei der Sensor auch entfernt von dem Bauteil, dann jedoch direkt oder indirekt kraftschlüssig/-gekoppelt und/oder formschlüssig/-gekoppelt zu dem Bauteil vorgesehen werden kann. Während der realen Nutzung des Bauteils werden dann Messwerte des Sensors erfasst. Als Messwerte eignen sich dabei insbesondere einfach zu ermittelnde Messwerte oder Messwerte, die bereits herkömmlich beim Betrieb des Bauteils, beispielsweise eines Fahrzeugs, erfasst werden. Typisch sind hier im Fahrzeugumfeld Größen, die z.B. als Eingangsgröße für Fahrerassistenzsysteme oder aktive Fahrwerke sowieso bereits erfasst werden (z.B. Fahrzeug- und/oder Radbeschleunigung, Lenkwinkel, Federwege), aus denen jedoch meist nicht direkt die beanspruchungs- oder bemessungsrelevanten Größen, wie beispielsweise Kräfte, Momente, Verschiebungen, Dehnungen oder Drücke an dem Bauteil, abgeleitet werden können.

Das erfindungsgemäße Verfahren sieht nun vor, das Bauteil bzw. ein System, das das Bauteil enthält, mittels eines Simulationsmodells darzustellen. Bei dem Simulationsmodell handelt es sich um ein vorteilhafterweise auf der Basis eines Mehrkörpersimulationsmodells abgeleitetes Modell oder ein Finite-Elemente-Modell mit Mehrkörpercharakteristik. Dieses simuliert das dynamische Verhalten des Systems und/oder Bauteils und ermöglicht die Berechnung der beanspruchungs- und bemessungsrelevanten Größen. Als Eingangsgrößen für das Simulationsmodell werden die oben genannten Messgrößen verwendet, die daher vergleichsweise einfach und damit wirtschaftlich vertretbar standardmäßig erfasst oder aus erfassten Größen abgeleitet werden können. Die ermöglicht es, die von den Sensoren erfassten Größen auch bei Bauteilen, die im Alltagsbetrieb verwendet werden, standardmäßig zu erfassen uns so die bemessungs- und beanspruchungsrelevanten Größen aus Werten des Alltagsbetriebs zu bestimmen.

Mittels des Simulationsmodells wird vorteilhafterweise die Dynamik des zu bewerteten Systems ausreichend genau beschrieben, um aus den Eingangsgrößen mit hinreichender Genauigkeit die beanspruchungs- bzw. bemessungsrelevanten Größen zeitnah (harte bzw. weiche Echtzeit) berechnen zu können. Typischerweise liegt also dem Simulationsmodell ein Mehrkörpersimulationsmodell zugrunde, dessen Komplexität erforderlichenfalls durch Verfahren der Modellreduktion so angepasst wird, dass in Abhängigkeit von der zur Verfügung stehenden Berechnungshardware die Berechnung ausreichend schnell durchgeführt werden kann.

Das Simulationsmodell liefert dann aus den sensorischen Eingangsgrößen beanspruchungs- bzw. bemessungsrelevante Größen, wie beispielsweise Schnittgrößen (Kräfte, Momente), Verschiebungen, Drücke, Dehnungen etc. für das zu betrachtende bzw. auszulegende Bauteil. Diese Größen dienen vorteilhafterweise dazu, beurteilen zu können, ob die im Betrieb aufgetretenen Beanspruchungen über die im Auslegungsprozess zugrundegelegten Auslegungskriterien hinausgehen und damit ein weiterer Betrieb mit einem hohen Versagensrisiko behaftet ist und/oder dazu, mittels der erfassten Daten eine bessere Datenbasis über im (Kunden- bzw. Alltags-)Betrieb aufgetretene Beanspruchungen zu erhalten und damit den zukünftigen Auslegungsprozess und zugehörige Bemessungs- und Beanspruchungsgrundlagen besser an die Realität anpassen zu können.

Als repräsentative Beanspruchungsgrößen, wie sie auch oben bereits exemplarisch genannt sind, werden typischerweise diejenigen Größen verwendet, die bei der Auslegung des Bauteils zugrundegelegt werden, um rechnerisch oder versuchstechnisch den Nachweis zu führen, dass das betrachtete System bzw. Bauteil hinsichtlich der Bemessungs- und/oder Beanspruchungsgrundlagen ausreichend dimensioniert ist.

Aus den in der Simulation berechneten Beanspruchungsgrößen werden vorteilhafterweise Kennwerte berechnet, die direkt im Zusammenhang mit den zugrundegelegten Bemessungsgrundlagen bzw. Beanspruchungsgrundlagen stehen. Typische Größen hierfür sind Schädigungszahlen, Laufleistung (in Streckenangaben bzw. Zeitangaben), Kollektive (Rainflow bzw. abgeleitete 2D-Kollektive, Überrollungskollektive) oder beispielsweise auch die Kategorie eines Ereignisses, wie beispielsweise besondere Ereignisse, wie Sondereignisse, z.B. Bordsteinrempler etc.

Aus den gemessenen Größen wird also der momentane Einsatzzustand im Vergleich zu den zugrundegelegten Bemessungsgrundlagen bestimmt und die Nutzung zur Kontrolle und als Grundlage zur Verbesserung der Qualität bei der Erstellung von Bemessungsgrundlagen und damit letztlich die Bestimmung von Kenngrößen für die Auslegung eines Bauteils bewirkt.

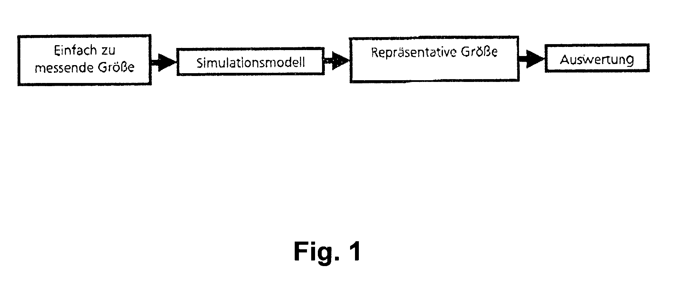

Figur 1 zeigt hier nochmals das Verfahren gemäß der vorliegenden Erfindung in einer schematischen Darstellung. Als Eingangssignal werden hier einfach zu messende Größen verwendet, aus denen mittels eines Simulationsmodells eine repräsentative Größe für die Auslegung des Bauteils ermittelt wird. Durch Auswertung kann dann der momentane Belastungszustand bzw. die tatsächliche Auslegung des Bauteils bzw. die Erfordernisse an die Auslegung des Bauteils ermittelt werden.

Vorteilhaft an dem erfindungsgemäßen Verfahren ist also, dass einfach und damit billig zu messende Größen als Grundlage verwendet werden können, um bauteilspezifische (beispielsweise fahrzeugspezifische) beanspruchungs- und/oder bemessungsrelevante Größen kostengünstig und auf breiter Basis zu ermitteln. Insbesondere können die im Betrieb auch im realen Einsatz tatsächlich aufgetretenen Beanspruchungen mit den vorab zugrunde gelegten Bemessungsgrundlagen verglichen werden. Dies ermöglicht beispielsweise eine Warnung des Systems, wenn ein Versagen wegen übermäßiger Beanspruchung nicht mehr ausgeschlossen werden kann. Weiterhin können die ermittelten Kenngrößen zur Verbesserung und Optimierung der Bemessungsgrundlagen und damit zur Verbesserung des Bauteils verwendet werden, da nunmehr fundierte Kenntnisse über die Höhe und Verteilung der Beanspruchung im realen Betrieb vorliegen.

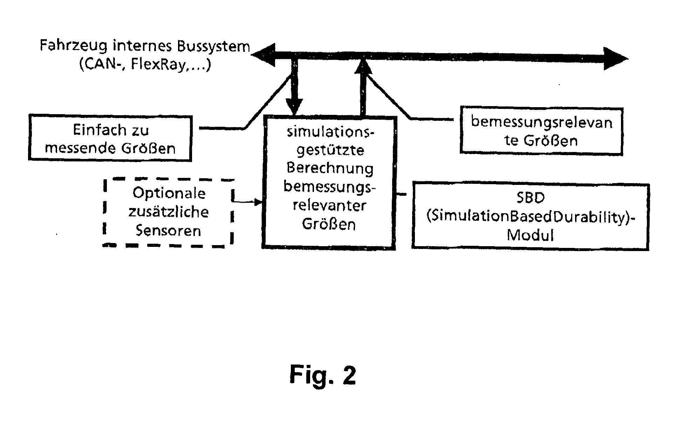

Im Folgenden wird anhand der Figur 2 ein Beispiel für die Anwendung des erfindungsgemäßen Verfahrens und ein Beispiel für eine erfindungsgemäße Vorrichtung in Form eines Fahrzeugs gegeben.

Figur 2 zeigt dabei ein fahrzeuginternes Bussystem, dem einfach zu messende Größen, beispielsweise aus dem Fahrerassistenzsystem zugeleitet werden. Diese Sensoren werden erfindungsgemäß zur simulationsgestützten Berechnung bemessungs- und beanspruchungsrelevanter Kenngrößen verwendet. Hier können auch weitere Messwerte aus optionalen zusätzlichen Sensoren zum Einsatz kommen. Die simulationsgestützte Berechnung erfolgt dabei mittels eines Simulationsmodells, dass in einem SBD-Modul zur Verfügung gestellt wird. Ausgangsgröße der simulationsgestützten Berechnung bemessungs- und/oder beanspruchungsrelevanter Größen sind die bemessungs- und/oder beanspruchungsrelevanten Größen selbst.

Die technische Anwendung besteht darin, dass Fahrzeuge mit Modulen ausgerüstet werden, die z.B. über das fahrzeuginterne CAN- oder FlexRay-Bussystem Messdaten erhalten und daraus mittels Simulation beanspruchungsrelevante bzw. bemessungsrelevante Größen berechnen. Die berechneten Größen, die in direktem Zusammenhang mit der Bemessung des Fahrzeugs stehen, können wieder in das Bussystem eingespeist oder auch auf dem Modul selbst abgespeichert werden.

Zu einem geeigneten Zeitpunkt können die Daten dann ausgelesen bzw. ausgewertet werden.

Möglichkeiten sind hierbei:
- Abspeichern der aktuellen Beanspruchung (im Vergleich zu den zu Grunde gelegten Bemessungsgrundlagen) z.B. im Fehlerspeicher des Fahrzeugs, bzw. gegebenenfalls die Ausgabe einer Fehlermeldung/Warnung,
- Speichern der aktuellen Belastungs- bzw. Beanspruchungshistorie im SBD-Modul, um diese bei Bedarf auslesen zu können,
- Online-Überwachung des Betriebs- bzw. Beanspruchungszustandes und gegebenenfalls optionale Übermittlung per Telemetrie, wie heute beispielsweise bereits zur Überwachung von Kühltemperaturen bei Lebensmitteltransporten eingesetzt.

Der Einsatz diese Module ist nicht auf PKW oder LKW bzw. Anhänger/Auflieger beschränkt. Insbesondere der Einsatz im Bereich der Nutzfahrzeuge allgemein (Landmaschinen, Baumaschinen), Booten oder Flugzeugen hat potenziell eine große Bedeutung.

Sehr effizient lässt sich dieses Verfahren insbesondere in den Bereichen einsetzen, in denen die Dynamiksimulation auf Basis von Mehrkörper- bzw. mehrkörperähnlichen Modellen schon im Entwicklungsprozess eingesetzt wird. Diese Modelle können prozesssicher als Grundlage für die im SBD-Modul verwendeten Modelle verwendet werden.

Letztendlich kann dann beim Einsatz dieser Module im Betrieb gewarnt werden, wenn in der Vergangenheit in der Summe übermäßig hohe Beanspruchungen aufgetreten sind und somit zumindest eine Inspektion durchgeführt werden sollte, um bestimmte Bauteile auf entstandene Schädigungen zu untersuchen.

Für die Hersteller bieten darüber hinaus die potentiell zur Verfügung stehenden Daten über die Beanspruchungshistorie einer Vielzahl von Bauteilen unter anderem im Alltagsbetrieb eine sehr gute Grundlage, um fundiert die Bemessungsgrundlagen für die zukünftige Auslegung von Fahrzeugen- bzw. Bauteilen an das tatsächliche Nutzungsverhalten im realen Kundenbetrieb anzupassen.

## Patentansprüche

1. Verfahren zur Bestimmung von beanspruchungs- und/oder bemessungsrelevanten Kenngrößen für die Auslegung eines Bauteils,
**dadurch gekennzeichnet,**
**daß** direkt oder indirekt kraftgekoppelt oder kraftschlüssig und/oder formgekoppelt oder formschlüssig zu dem Bauteil mindestens ein Sensor zur Erfassung von dynamischen Größen vorgesehen ist;
während der Nutzung im bestimmungsgemäßen Gebrauch Messwerte von dem mindestens einen Sensor erfaßt wird;
das Bauteil und/oder sein Verhalten mittels eines Simulationsmodells dynamisch simuliert wird; beanspruchungs- und/oder bemessungsrelevante Kenngrößen des Bauteils aus den erfaßten Messwerten mittels des Simulationsmodells abgeleitet werden.

2. Verfahren nach dem vorhergehenden Anspruch, **dadurch gekennzeichnet, daß** aus den beanspruchungs- und/oder bemessungsrelevanten Kenngrößen die Belastung des Bauteils verglichen mit seiner Auslegung und/oder eine Empfehlung für die Auslegung des Bauteils bestimmt wird

3. Verfahren nach einem der vorhergehenden Ansprüche, **dadurch gekennzeichnet, daß** die Meßgrößen einfach zu ermittelnde Meßgrößen, insbesondere Beschleunigungen wie Rad- und/oder Fahrzeugbeschleunigungen, Winkel wie Lenkwinkel und/oder Federwege, sind, aus denen gegebenenfalls nicht direkt beanspruchungs- und/oder bemessungsrelevante Größen, insbesondere Kräfte, Momente, Verschiebungen, Dehnungen, Stauchungen und/oder Drücke, die auf das Bauteil wirken, abgeleitet werden können

4. Verfahren nach einem der vorhergehenden Ansprüche, **dadurch gekennzeichnet, daß** als Meßgrößen Meßgrößen verwendet werden, die aufgrund anderer Anforderungen, insbesondere als Betriebsassistenzsysteme, erfaßt werden.

5. Vorrichtung mit mindestens einem Bauteil,
**gekennzeichnet durch**
mindestens einen Sensor zur Erfassung von dynamischen Größen der Vorrichtung während der Nutzung der Vorrichtung im bestimmungsgemäßen Gebrauch;
eine Vorrichtung zur Ableitung von beanspruchungs- und/oder bemessungsrelevante Größen des Bauteils aus den erfaßten Messwerten mittels eines Simulationsmodells zur dynamischen Simulation des Bauteils und/oder seines Verhaltens; und
eine Vorrichtung zur Speicherung und/oder Ausgabe der abgeleiteten beanspruchungs- und/oder bemessungsrelevanten Größen.

6. Vorrichtung nach dem vorhergehenden Anspruch, **gekennzeichnet durch** eine Vorrichtung zur Bestimmung der Belastung des Bauteils verglichen mit seiner Auslegung und/oder eine Empfehlung zur Auslegung des Bauteils aus den beanspruchungs- und/oder bemessungsrelevanten Größen.

7. Vorrichtung nach einem der beiden vorhergehenden Ansprüche, **dadurch gekennzeichnet, daß** der mindestens eine Sensor Meßgrößen einfach zu ermittelnde Meßgrößen, insbesondere Beschleunigungen wie Rad- und/oder Fahrzeugbeschleunigungen, Winkel wie Lenkwinkel und/oder Federwege, erfaßt, aus denen gegebenenfalls nicht direkt beanspruchungs- und/oder bemessungsrelevante Größen, insbesondere Kräfte, Momente, Verschiebungen, Dehnungen, Stauchungen und/oder Drücke, die auf das Bauteil wirken, abgeleitet werden können

8. Vorrichtung nach einem der drei vorhergehenden Ansprüche, **dadurch gekennzeichnet, daß** der mindestens eine Sensor Meßgrößen erfaßt, die aufgrund anderer Anforderungen, insbesondere in Betriebsassistenzsystemen, erfaßt werden.

9. Vorrichtung nach einem der Ansprüche 5 bis 8, **dadurch gekennzeichnet, daß** die Vorrichtung ein Transportmittel, insbesondere ein Land-, Luft- oder Wasserfahrzeug ist, wobei gegebenenfalls der mindestens eine Sensor Element eines Fahrzeugführerassistenzsystems und/oder eines aktiven Fahrwerks ist.

10. Verfahren oder Vorrichtung nach einem der vorhergehenden Ansprüche, **dadurch gekennzeichnet, daß** das Simulationsmodell ein Mehrkörpersimulationsmodel ist.

11. Verfahren oder Vorrichtung nach einem der vorhergehenden Ansprüche, **dadurch gekennzeichnet, daß** die beanspruchungs- und/oder bemessungsrelevante Größen Kräfte, Moment, Verschiebungen, Dehnungen, Drücke und dergleichen sind.

12. Verfahren oder Vorrichtung nach einem der vorhergehenden Ansprüche, **dadurch gekennzeichnet, daß** aus den beanspruchungs- und/oder bemessungsrelevante Größen Bauteilkennwerte, insbesondere Schädigungszahlen, Laufleistungen, Kollektive oder Kategorien von Ereignissen bestimmt werden.
